Europäisches Patentamt

European Patent Office

Office européen des brevets

(19)

(11) Publication number: **0 296 706 B1**

# EUROPEAN PATENT SPECIFICATION

(12)

(45) Date of publication of patent specification: **23.02.94**     (51) Int. Cl.[5]: **H01L 35/22**, H01L 37/02

(21) Application number: **88304235.0**

(22) Date of filing: **10.05.88**

(54) **A thermoelectric material.**

(30) Priority: **26.06.87 JP 160680/87**

(43) Date of publication of application:
**28.12.88 Bulletin  88/52**

(45) Publication of the grant of the patent:
**23.02.94 Bulletin  94/08**

(84) Designated Contracting States:
**DE FR GB**

(56) References cited:
**EP-A- 0 288 022**
**GB-A- 2 207 321**

**PHYSICAL REVIEW B/CONDENSED MATTER,
vol. 34, no. 10, 15th November 1986, pages
6972-6979, The American Physical Society,
Woodbury, NY, US; G.M. CHOI et al.: "Elec-
tronic-transport behavior in single-crystal-
line BA0.03Sr0.97TiO3"**

**JOURNAL OF PHYSICS D/APPLIED PHYSICS,
vol. 21, no. 2, 14th February 1988, pages
344-348, IOP Publishing Ltd, Bristol, GB; H.J.
GOLDSMID et al.: "High-Tc superconductors
as passive thermo-elements"**

(73) Proprietor: **SHARP KABUSHIKI KAISHA
22-22 Nagaike-cho
Abeno-ku
Osaka 545(JP)**

(72) Inventor: **Yoshimoto, Yoshikazu
202 Yabuuchi-haitsu
298, Tainosho-cho
Tenri-shi Nara-ken(JP)**
Inventor: **Ohno, Eizo
2613-1, Ichinomoto-cho
Tenri-shi Nara-ken(JP)**
Inventor: **Yoshida, Masaru
5-6-1, Tatsutakita
Ikaruga-cho
Ikoma-gun Nara-ken(JP)**
Inventor: **Nakajima, Shigeo
603 Grace Shinohmiya
2-7-1, Ohmiya-cho
Nara-shi Nara-ken(JP)**
Inventor: **Kataoka, Shoei
3-20-16, Shibakubo-cho
Tanashi-shi Tokyo(JP)**

(74) Representative: **White, Martin David et al
MARKS & CLERK
57/60 Lincoln's Inn Fields
London WC2A 3LS (GB)**

PHISICAL REVIEW LETTERS, vol. 58, No. 4 ,pp. 405-407 & 408-410.

PHISICAL REVIEW LETTERS, Vol.58, No. 9,pp.908-910.

**Description**

BACKGROUND OF THE INVENTION

1. Field of the invention:

This invention relates to a thermoelectric material that is useful in generating electrical energy by the use of temperature differences (based on the Seebeck effect) and in generating temperature differences from electrical energy (based on the Peltier effect). More particularly, it relates to a thermoelectric material consisting of an oxide with a perovskite structure or a layered perovskite structure, wherein the oxide is composed of a rare earth element and a transition metal element, and exhibits large thermoelectric power at low temperatures below room temperature.

2. Description of the prior art:

As is well known, the thermoelectrical property, which is expressed by the efficiency of conversion between thermal energy and electrical energy, can be evaluated in terms of the thermoelectric figure of merit Z. The value of Z can be estimated by the equation $Z = \alpha^2\lambda/k$. Here, $\alpha$ is the thermoelectric power ($\mu VK^{-1}$), $\lambda$ is the electrical conductivity ($\Omega^{-1} \cdot cm^{-1}$), and k is the thermal conductivity ($W \cdot cm^{-1}K^{-1}$). Of course, in order to obtain a large thermoelectric figure of merit, a large $\alpha$, a large $\lambda$, and a small k are required. However, it is well known that $\lambda/k$ for metals is expected to be a constant by the Wiedemann-Franz law, and that the three constants mentioned above are not necessarily independent. This law is not always applicable to the case of a semiconductor, so the selection from semiconductors to produce a thermoelectric material is relatively unrestricted. Also, the value of $\alpha$ for metals is of the order of 10 $\mu V/K$, but a number of semiconductors have the value of $\alpha$ higher than the value for metals by one or more orders of magnitude. Examples of typical thermoelectric materials that have been previously developed include polycrystalline silicides of transition metal used for thermoelectrical power generation, and chalcogenides of bismuth or antimony used for cooling based on the Peltier effect. Among them, $Bi_2Te_3$-type compounds have thermoelectric figures of merit that are the best at temperatures around room temperatures, and it is well known that they have come into use as Peltier elements in electronic cooling apparatuses and the like. However, as this material has thermoelectric figures of merit that decrease very much below room temperature, the cooling temperature is restricted at present only within an extremely narrow temperature range around room temperature. For this reason, it is required to develop a thermoelectric material for cooling based on the Peltier effect, which has a large thermoelectric figure of merit over a wide range of temperatures below room temperature.

Physical Review Letters Vol. 58, No. 4, pp 405-407 discloses that La-Ba-Cu-O oxides having a perovskite structure exhibit superconductivity, with a critical temperature of around 25K or greater.

Physical Review Letters Vol. 58, No. 4, pp 408-410 discloses that La-Sr-Cu-O oxides having a perovskite structure exhibit superconductivity. The critical temperature for $La_{1.8}Sr_{0.2}CuO_4$ is found to be 36K.

Physical Review Letters Vol. 58, No. 9, pp 908-910 discloses that Y-Ba-Cu-O oxides having a perovskite structure exhibit superconductivity, with a critical temperature of 80K to 93K.

SUMMARY OF THE INVENTION

According to a first aspect of the present invention there is provided a Peltier effect device comprising a thermoelectric material consisting of an oxide with a perovskite structure,
wherein said oxide is of the formula

$(Ln_{1-x}A_x)_2MO_4$ (0<x<1),

wherein Ln is a rare earth element, A is an alkaline earth metal element and M is a transition metal element, and wherein said oxide is used in creating the Peltier effect in the device.

In a preferred embodiment, the thermoelectric material is in the form of a solid solution.

In a preferred embodiment, the rare earth element is selected from the group consisting of yttrium (Y), lanthanum (La), dysprosium (Dy), ytterbium (Yb) and samarium (Sm).

In a preferred embodiment, the transition metal element is selected from the group consisting of copper (Cu), titanium (Ti), iron (Fe), nickel (Ni), zinc (Zn), cobalt (Co) and manganese (Mn).

In a preferred embodiment, the alkaline earth element is selected from the group consisting of calcium (Ca), strontium (Sr) and barium (Ba).

According to a second aspect of the present invention there is provided a thermoelectric element comprising a junction between a first electrical conductor and a second electrical conductor;

said thermoelectric element being characterised in that one of said first and second electrical conductors is formed of an oxide with a perovskite structure, said oxide having the formula $(Ln_{1-x}A_x)_2Ma_yMb_{1-y}O_4$

or $(Ln_{1-x}A_x)Ma_yMb_{1-y}O_3$ (0<x<1, 0<y<1),

wherein Ln is a rare earth element, A is an alkaline-earth element, Ma is a transition metal element and Mb is a transition metal element.

The oxides with a perovskite structure that constitute the thermoelectric materials of this invention can be represented by the chemical formula $LnMO_3$ or $Ln_2MO_4$, wherein Ln is a rare earth element and M is a transition metal element. As mentioned above, at least one part of the said rare earth element can be replaced by an alkaline-earth element, or at least one part of the said transition metal element can be replaced by another kind of transition metal element.

In an evaluation of oxides in which lanthanum and yttrium are used as rare earth elements, copper as a transition metal element, and barium and strontium as alkaline-earth metal elements, the following results were obtained. These oxides with a perovskite structure have large thermoelectric figures of merit over a wide temperature range form room temperature to 100 K or less, the values of which are higher than the largest thermoelectric figure of merit known to date, that of the thermoelectric material of the Bi-Te type. Also, the temperature characteristics thereof do not decline up to a temperature lower than 100 K.

Examples of methods for the preparation of the oxides of this invention include the sputtering method, the coprecipitation method, the melting method, the powder sintering method, and the like. Here, the powder sintering method is given as an example therefor, but the structure and characteristics of the oxides of this invention are not limited to this method of preparation.

Thus, the invention described herein makes possible the objectives of (1) providing a thermoelectric material consisting an oxide with a perovskite structure, which has large thermoelectric figures of merit from room temperature to 100 K or less, and the temperature characteristics of which do not decline up to a temperature lower than 100 K, resulting in a Peltier cooling element with which cooling temperatures lower than room temperature can be attained; and (2) providing a thermoelectric material that can be easily produced at low cost, and with ready control of its thermoelectric power to either the P- or N-type, resulting in a Peltier cooling element with high performance that is economical to produce and has a wide range of applications.

## BRIEF DESCRIPTION OF THE DRAWING

This invention may be better understood and its numerous objectives and advantages will become apparent to those skilled in the art by reference to the accompanying drawing as follows:

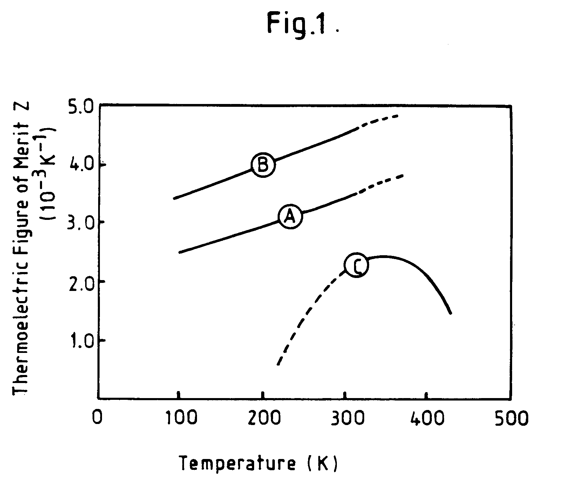

Figure 1 is of characteristic curves showing the temperature dependences of the thermoelectric figures of merit for the oxides with a perovskite structure (i.e., $(La_{1-x}Ba_x)_2CuO_4$ and $(La_{1-x}Sr_x)_2CuO_4$) of this invention and for the conventional thermoelectric material of the Bi-Te type.

## DESCRIPTION OF THE PREFERRED EMBODIMENTS

### Example 1

First, lanthanum oxide ($La_2O_3$), barium carbonate ($BaCO_3$), and cupric oxide (CuO) were weighed separately, mixed together well in a mortar, and pre-fired for 12 hours at 900°C. Then, the resulting product was ground into a powder and mixed well followed by further firing for about 5 hours at 1100°C. The thermoelectric material obtained, $(La_{1-x}Ba_x)_2CuO_4$, was analyzed for its structure by X-ray diffraction. The results showed that the material of this example had a perovskite structure.

Next, the thermoelectric material obtained in this way was evaluated in terms of its thermoelectric figure of merit Z ($Z = \alpha^2\lambda/k$), which was calculated from its thermoelectric power $\alpha$, electrical conductivity $\lambda$, and thermal conductivity k at temperatures from 100 K to room temperature. The results are shown in Table 1. The type of thermoelectric power changes depending on the fraction x of the alkaline-earth metal element and the amount of oxygen. Here, data on the thermoelectric material of the P-type are given in Table 1 as an example.

## Table 1

### Thermoelectrical properties of $(La_{1-x}Ba_x)_2CuO_4$ (P-type)

| Temperature (K) | 100 | 200 | 300 |
|---|---|---|---|
| Thermoelectric power $\alpha$ ($\mu VK^{-1}$) | 450 | 440 | 430 |
| Thermal conductivity k ($W \cdot cm^{-1}K^{-1}$) | $8 \times 10^{-3}$ | $7 \times 10^{-3}$ | $6 \times 10^{-3}$ |
| Electrical conductivity $\lambda$ ($\Omega^{-1} \cdot cm^{-1}$) | 100 | 105 | 110 |
| Thermoelectric figure of merit Z ($\times 10^{-3}K^{-1}$) | 2.5 | 2.9 | 3.4 |

The temperature characteristics of the thermoelectric figures of merit for the oxides of this invention and for the conventional thermoelectric material of the Bi-Te type are also compared in Figure 1. Curves A and B in Figure 1 are the characteristic curves for the thermoelectric materials of this invention, that is, $(La_{1-x}Ba_x)_2CuO_4$ and $(La_{1-x}Sr_x)_2CuO_4$, respectively. These materials are of the P-type, and the latter material is fully described in the following Example 2. Curve C in Figure 1 also shows the characteristic curve for the conventional thermoelectric material of the Bi-Te type. As is clear from Curves A and C in Figure 1, the thermoelectric figure of merit for the oxide of this example is higher than the value for the material of the Bi-Te type at temperatures around room temperature, and characteristically declined only slightly at lower temperatures, even at 100 K.

Example 2

First, lanthanum oxide ($La_2O_3$), strontium carbonate ($SrCO_3$), and cuprous oxide ($Cu_2O$) were weighted separately, mixed together well in a mortar, and pre-fired for 12 hours at 900 °C. Then, the pre-fired mixture was ground into a powder and again mixed well followed by further firing for about 5 hours at 1100 °C. The thermoelectric material obtained, $(La_{1-x}Sr_x)_2CuO_4$, was analyzed for its structure by X-ray diffraction. It was found, as in Example 1, that the material of this example had a perovskite structure. Also, the thermoelectric power, thermal conductivity, electrical conductivity, and thermoelectric figure of merit were obtained at temperatures from 100 K to room temperature. The variations in these values with temperature are shown in Table 2. As shown in Table 2, even at the low temperature of 100 K, the thermoelectric figure of merit was still high, being $3.4 \times 10^{-3}$ $K^{-1}$. Moreover, it is obvious from Curves B and C in Figure 1 that the thermoelectric material of this example has temperature characteristics superior to those of the conventional thermoelectric material of the Bi-Te type.

## Table 2

**Thermoelectrical properties of $(La_{1-x}Sr_x)_2CuO_4$ (P-type)**

| Temperature (K) | 100 | 200 | 300 |
|---|---|---|---|
| Thermoelectric power $\alpha(\mu VK^{-1})$ | 400 | 390 | 380 |
| Thermal conductivity k $(W \cdot cm^{-1}K^{-1})$ | $4.0 \times 10^{-3}$ | $3.5 \times 10^{-3}$ | $3.0 \times 10^{-3}$ |
| Electrical conductivity $\lambda (\Omega^{-1} \cdot cm^{-1})$ | 85 | 90 | 95 |
| Thermoelectric figure of merit Z $(\times 10^{-3}K^{-1})$ | 3.4 | 3.9 | 4.6 |

Example 3

First, yttrium oxide ($Y_2O_3$), barium carbonate ($BaCO_3$), and cupric oxide (CuO) were weighed separately, and then mixed together in the same manner as in Example 1 and 2. Then, the mixture was pre-fired at 700°C for 12 hours, followed by firing at 900°C in an atmosphere with an excess of oxygen for about 6 hours. The thermoelectric material prepared by these firings, $(Y_{1-x}Ba_x)_2CuO_4$, had the same structure as those obtained in Examples 1 and 2, but the thermoelectric power thereof was of the N-type. The thermoelectric figure of merit was $3.0 \times 10^{-3}$ $K^{-1}$ at 100 K, and its variation with temperature was the same as that shown in Examples 1 and 2.

**Claims**

1. A Peltier effect device comprising a thermoelectric material consisting of an oxide with a perovskite structure,
   wherein said oxide is of the formula

   $(Ln_{1-x}A_x)_2MO_4$ (0<x<1),

   wherein Ln is a rare earth element, A is an alkaline earth metal element and M is a transition metal element, and wherein said oxide is used in creating the Peltier effect in the device.

2. A Peltier effect device according to claim 1, which is in the form of a solid solution.

3. A Peltier effect device according to claim 1 or 2, wherein said rare earth element is selected from the group consisting of yttrium (Y), lanthanum (La), dysprosium (Dy), ytterbium (Yb) and samarium (Sm).

4. A Peltier effect device according to claim 1, 2 or 3, wherein said transition metal element is selected from the group consisting of copper (Cu), titanium (Ti), iron (Fe), nickel (Ni), zinc (Zn), cobalt (Co) and manganese (Mn).

5. A Peltier effect device according to any preceding claim, wherein said alkaline earth element is selected from the group consisting of calcium (Ca), strontium (Sr) and barium (Ba).

6. A thermoelectric element comprising a junction between a first electrical conductor and a second electrical conductor;

said thermoelectric element being characterised in that one of said first and second electrical conductors is formed of an oxide with a perovskite structure, said oxide having the formula $(Ln_{1-x}A_x)_2Ma_yMb_{1-y}O_4$ or $(Ln_{1-x}A_x)Ma_yMb_{1-y}O_3$ (0<x<1, 0<y<1), wherein Ln is a rare earth element, A is an alkaline-earth element, Ma is a transition metal element and Mb is a transition metal element.

7. A thermoelectric element according to claim 6 wherein said thermoelectric element is a Peltier element.

8. A thermoelectric element according to claim 6 or 7, wherein said rare earth element is selected from the group consisting of yttrium (Y), lanthanum (La), dysprosium (Dy), ytterbium (Yb) and samarium (Sm).

9. A thermoelectric element according to any of claims 6 to 8, wherein said first and second transition metal elements are selected from the group consisting of copper (Cu), titanium (Ti), iron (Fe), nickel (Ni), zinc (Zn), cobalt (Co) and manganese (Mn).

10. A thermoelectric element according to any of claims 6 to 9, wherein said alkaline earth element is selected from the group consisting of calcium (Ca), strontium (Sr) and barium (Ba).

**Patentansprüche**

1. Peltier-Effekt-Vorrichtung mit einem thermoelektrischen Material, das aus einem Oxid mit einer Perowskit-Struktur besteht, wobei das Oxid die Formel

$$(Ln_{1-x}A_x)_2\,MO_4\,(0<x<1)$$

hat, wobei Ln ein Element der seltenen Erden ist, A ein Element aus den Erdalkalimetallen ist und M ein Element aus den Übergangsmetallen ist und wobei das Oxid dazu verwendet wird, den Peltier-Effekt in der Vorrichtung hervorzurufen.

2. Peltier-Effekt-Vorrichtung nach Anspruch 1, die in Form einer festen Lösung vorliegt.

3. Peltier-Effekt-Vorrichtung nach Anspruch 1 und 2, wobei das Seltenerdelement aus der aus Yttrium (Y), Lanthan (La), Dysprosium (Dy), Ytterbium (Yb) und Samarium (Sm) bestehenden Gruppe ausgewählt ist.

4. Peltier-Effekt-Vorrichtung nach Anspruch 1, 2 oder 3, wobei das Übergangsmetallelement aus der aus Kupfer (Cu), Titan (Ti), Eisen (Fe), Nickel (Ni), Zink (Zn), Cobalt (Co) und Mangan (Mn) bestehenden Gruppe ausgewählt ist.

5. Peltier-Effekt-Vorrichtung nach einem der vorhergehenden Ansprüche, wobei das Erdalkalimetall aus der aus Calizium (Ca), Strontium (Sr) und Barium (Ba) bestehenden Gruppe ausgewählt ist.

6. Thermoelektrisches Element, welches einen Übergang zwischen einem ersten elektrischen Leiter und einem zweiten elektrischen Leiter aufweist; wobei das thermoelektrische Element dadurch gekennzeichnet ist, daß einer von dem ersten und dem zweiten elektrischen Leiter aus einem Oxid mit einer Perowskit-Struktur gebildet ist, wobei das Oxid die Formel hat $(Ln_{1-x}A_x)_2Ma_yMb_{1-y}O_4$ oder $(Ln_{1-x}A_x)Ma_yMb_{1-y}O_3$ (0<x<1, 0<y<1), wobei Ln ein Element der seltenen Erden ist, A ein Element der Erdalkalimetalle ist, Ma ein Element der Übergangsmetalle und Mb ein Element der Übergangsmetalle ist.

7. Thermoelektrisches Element nach Anspruch 6, wobei das thermoelektrische Element ein Peltier-Element ist.

**8.** Thermoelektrisches Element nach Anspruch 6 oder 7, wobei das Element der seltenen Erden aus der aus Yttrium (Y), Lanthan (La), Dysprosium (Dy), Ytterbium (Yb) und Samarium (Sm) bestehenden Gruppe ausgewählt ist.

**9.** Thermoelektrisches Element nach einem der Ansprüche 6 bis 8, wobei das erste und zweite Übergangsmetallelement aus der aus Kupfer (Cu), Titan (Ti), Eisen (Fe), Nickel (Ni), Zink (Zn), Cobalt (Co) und Mangan (Mn) bestehenden Gruppe ausgewählt ist.

**10.** Thermoelektrisches Element nach einem der Ansprüche 6 bis 9, wobei das Erdalkalimetallelement aus der aus Calzium (Ca), Strontium (Sr) und Barium (Ba) bestehenden Gruppe ausgewählt ist.

**Revendications**

**1.** Dispositif à effet Peltier comprenant une matière thermoélectrique consistant en un oxyde à structure de perovskite,

dans lequel ledit oxyde est de la formule

$$(Ln_{1-x}A_x)_2MO_4 \quad (0<x<1),$$

où Ln est un élément des terres rares, A est un élément métallique alcalino-terreux et M est un élément métallique de transition et dans lequelledit oxyde est utilisé pour créer, dans le dispositif, l'effet Peltier.

**2.** Dispositif à effet Peltier selon la revendication 1, qui est en forme de solution solide.

**3.** Dispositif à effet Peltier selon la revendication 1 ou 2, dans lequel ledit élément des terres rares est choisi dans le groupe constitué par l'yttrium (Y), le lanthane (La), le dysprosium (Dy), l'ytterbium (Yb) et le samarium (Sm).

**4.** Dispositif à effet Peltier selon la revendication 1, 2 ou 3, dans lequel ledit élément métallique de transition est choisi dans le groupe constitué par le cuivre (Cu), le titane (Ti), le fer (Fe), le nickel (Ni), le zinc (Zn), le cobalt (Co) et le manganèse (Mn).

**5.** Dispositif à effet Peltier selon une revendication précédente quelconque, dans lequel ledit élément alcalino-terreux est choisi dans le groupe constitué par le calcium (Ca), le strontium (Sr) et le baryum (Ba).

**6.** Elément thermoélectrique comprenant une jonction entre un premier conducteur électrique et un deuxième conducteur électrique;

ledit élément thermoélectrique étant caractérisé en ce que, soit le premier, soit le deuxième conducteur électrique est formé d'un oxyde à structure de perovskite, la formule dudit oxyde étant $(Ln_{1-x}A_x)_2Ma_yMb_{1-y}O_4$ ou $(Ln_{1-x}A_x)Ma_yMb_{1-y}O_3$ $(O<x<1, o<y<1)$,

où Ln est un élément des terres rares, A est un élément alcalino-terreux, Ma est un élément métallique de transition et Mb et un élément métallique de transition.

**7.** Elément thermoélectrique selon la revendication 6 dans lequel ledit élément thermoélectrique est un élément de Peltier.

**8.** Elément thermoélectrique selon la revendication 6 ou 7, dans lequel ledit élément des terres rares est choisi dans le groupe constitué par l'yttrium (Y), le lanthane (La), le dysprosium (Dy), l'ytterbium (Yb) et le samarium (Sm).

**9.** Elément thermoélectrique selon l'une quelquonque des revendications 6 à 8, dans lequel ledit premier et ledit second éléments métalliques de transition sont choisis dans le groupe constitué par le cuivre (Cu), le titane (Ti), le fer (Fe), le nickel (Ni), le zinc (Zn), le cobalt (Co) et le manganèse (Mn).

**10.** Elément thermoélectrique selon l'une quelconque des revendications 6 à 9, dans lequel ledit élément alcalino-terreux est choisi dans le groupe constitué par le calcium (Ca), le strontium (Sr) et le baryum

(Ba).

## Fig.1.